# FASCICULE DE BREVET EUROPEEN

(11) **EP 3 973 302 B1**
(45) Date de publication et mention de la délivrance du brevet: **14.09.2022**
(21) Numéro de dépôt: 21732952.3
(22) Date de dépôt: 29.04.2021
(51) Int. Cl.: G01R 15/20, H01R 39/38, H02K 5/14, G01R 31/34, H02K 11/27

(54) **DISPOSITIF CAPTEUR DE COURANT ET PROCÉDÉ D'ASSEMBLAGE D'UN TEL DISPOSITIF**
STROMSENSORVORRICHTUNG UND VERFAHREN ZUM ZUSAMMENBAU EINER SOLCHEN VORRICHTUNG
CURRENT SENSOR DEVICE AND METHOD FOR ASSEMBLING SUCH A DEVICE

(30) Priorité: 30.04.2020 FR 2004293
(43) Date de publication de la demande: 30.03.2022
(73) Titulaire: Mersen France Amiens SAS, 80080 Amiens (FR)
(72) Inventeur: RAMLALL, Radjy, 59290 Wasquehal (FR); WHITE, Benoit, River Edge, New Jersey 07661 (US)
(74) Mandataire: Fédit-Loriot
(86) Numéro de dépôt international: PCT/FR2021/050740
(87) Numéro de publication internationale: WO 2021/219962

(56) Documents cités:
- CN-B- 102 169 136
- CN-B- 107 861 062
- RU-C1- 2 157 033
- US-A1- 2014 346 931

## Description

L'invention se rapporte à la mesure du courant électrique traversant un balai destiné à assurer un contact électrique entre une pièce / élément fixe et une pièce / élément mobile. L'invention peut trouver une application par exemple dans les machines électriques tournantes, notamment asynchrones, les moteurs, les générateurs, en particulier les génératrices d'éoliennes.

Un balai est un contact électrique glissant transmettant le courant électrique entre une pièce / élément fixe et une pièce / élément en rotation, ou vice versa. Les balais peuvent être utilisés dans des appareils électriques tels que des générateurs ou des moteurs électriques, dont l'élément en rotation peut être un collecteur ou un ensemble de bagues collectrices. En général, un balai est constitué d'un ou plusieurs blocs en matériau conducteur, généralement à base de graphite, le plus souvent muni d'un câble. Ces balais sont supportés par des porte-balais.

Le fonctionnement des balais peut dépendre de nombreux paramètres tels que la température ambiante, l'état de la surface de contact, le courant qui traverse chaque balai, les vibrations, etc. Dans une machine à haute puissance, plusieurs balais sont montés en parallèle électriquement. Le courant est ainsi réparti entre les différents balais, ce qui peut perturber leur fonctionnement en cas de distribution asymétrique du courant : un balai traversé par un courant faible agira comme une pierre abrasive, tandis qu'un autre balai traversé par un courant élevé chauffera. La résistance électrique de ce dernier va augmenter, en particulier au niveau du point de connexion avec le câble électrique auquel il est relié, ce qui peut provoquer la déconnexion du balai par arrachement du câble, et augmenter le courant électrique traversant les autres balais, et au final un possible arrachement de tous les câbles reliés aux balais.

C'est la raison pour laquelle, depuis plusieurs années, la surveillance du courant traversant les balais s'avère primordiale pour les utilisateurs de machine électrique tournante.

Le courant traversant les balais peut être surveillé par une résistance de captage de courant (« shunt sensor » ou « current-sense resistor » en anglais). Ce système présente l'avantage d'être peu coûteux et largement utilisé. Toutefois, une partie du courant peut être perdue et la surveillance de chaque balai est difficile en raison de l'encombrement du dispositif.

Il est connu d'utiliser un capteur à effet Hall pour mesurer le courant traversant un balai. Un capteur à effet Hall est sensible au flux magnétique créé par un flux de courant et génère une tension représentative de ce courant. De tels capteurs présentent l'avantage de ne pas perturber le courant à mesurer. Toutefois, on observe des perturbations et des pertes dans la mesure du courant dues à la sensibilité de ces capteurs à l'environnement magnétique et aux sources externes de magnétisme. En outre, les montages sont souvent relativement complexes, ces capteurs étant en général montés sur les câbles alimentant les balais.

Le document CN102169136 décrit notamment un dispositif de surveillance en ligne du courant d'un balai de générateur. Ce dispositif comprend un capteur à effet Hall installé en amont du balai, sur la plaque d'amenée de courant et de raccordement du câble du balai sur le porte-balais. Le capteur à effet Hall ne mesure donc pas le courant traversant le balai, mais celui traversant la plaque d'amenée de courant.

Il est également connu d'utiliser un capteur à effet Hall pour mesurer le courant d'un câble connecté à un balai. Ainsi, le document RU2157033C1 décrit un outil de mesure du courant d'un câble connecté à un balai. Cet outil nécessite cependant l'intervention d'un opérateur et ne peut mesurer le courant traversant le bloc du balai, mais uniquement celui traversant le câble connecté au balai.

Le document CN107861062B décrit un dispositif de surveillance en ligne d'un générateur utilisant un capteur à effet Hall situé entre deux extrémités d'un anneau supportant un enroulement, autrement dit un tore actif. Le signal de sortie du capteur du capteur à effet Hall est représentatif d'un changement de la valeur du courant traversant un ou plusieurs balais. Le capteur à effet Hall ne mesure donc pas une valeur du courant. Ce document ne précise pas non plus la position du capteur à effet Hall.

Il existe donc un besoin pour un dispositif capteur de courant qui permette la surveillance d'un balai d'une machine électrique tournante qui soit fiable et efficace. Il existe également un besoin pour un dispositif capteur de courant compact, peu coûteux et facile à monter.

Il est proposé un dispositif capteur de courant pour surveiller le courant traversant un balai comprenant :
- un support de balai s'étendant suivant une direction longitudinale entre des extrémités distale et proximale, et définissant un logement traversant destiné à recevoir de manière coulissante suivant la direction longitudinale un balai de sorte qu'une extrémité du balai destinée à frotter contre une surface mobile tournante, fasse saillie du support de balai du côté de son extrémité distale,
- un capteur à effet Hall conformé pour détecter un champ magnétique,
- un concentrateur conformé pour concentrer les champs magnétiques à l'intérieur d'une zone de champ magnétique concentré et pour protéger cette zone des champs magnétiques externes, dans lequel,

- le concentrateur est monté sur le support de balai de manière à entourer au moins une partie du balai lorsque ce dernier est reçu à l'intérieur du logement du support de balai, notamment dans un plan perpendiculaire à la direction longitudinale,
- le capteur à effet Hall est monté sur le support de balai à une position située à l'intérieur de la zone de champ magnétique concentré, de manière à mesurer une valeur représentative de l'intensité du courant traversant le balai lorsque ce dernier est reçu dans le logement du support de balai.

Le concentrateur entoure ainsi au moins une partie du balai lorsque ce dernier est reçu dans le logement du support de balai de sorte que le champ magnétique généré par le flux de courant traversant le balai est concentré par le concentrateur. La présence du concentrateur permet de concentrer et d'augmenter le flux magnétique généré par le courant traversant un balai reçu dans le logement du support de balai, améliorant ainsi la précision de la mesure. Le concentrateur permet également de protéger le capteur à effet Hall de l'influence de champs magnétiques provenant de sources externes. En outre, un tel agencement est compact, ce qui permet de prévoir un capteur de courant par support de balai et donc par balai, améliorant la surveillance d'une machine électrique tournante équipée d'une pluralité de balais.

On notera que le concentrateur peut être monté à l'extérieur du support de balai de manière à entourer au moins partiellement le logement. Il entoure alors des parois du support de balai définissant le logement. Le concentrateur peut également être monté à l'intérieur du support de balai de manière à entourer au moins partiellement le logement. Dans ce cas, il peut définir au moins partiellement le logement et être lui-même entouré des parois du support de balai. Autrement dit, dans tous les cas, le concentrateur est monté sur le support de balai de manière à entourer au moins partiellement un balai disposé à l'intérieur du logement.

Avantageusement, le capteur à effet Hall peut être sensible à un champ magnétique s'étendant parallèlement à sa surface. C'est par exemple le cas des capteurs utilisant la technologie IMC-Hall^{®} (Integrated Magneto-Concentrator). Ce type de capteur peut alors être disposé de manière à s'étendre parallèlement à la direction longitudinale du support de balai de manière à mesurer un courant électrique circulant suivant la direction longitudinale. Ceci permet de limiter davantage l'encombrement du dispositif capteur de courant.

Le capteur à effet Hall et le concentrateur peuvent être positionnés en tout point du support de balai suivant sa direction longitudinale. Toutefois, du côté de l'extrémité proximale du support de balai, à savoir à l'opposé de l'extrémité distale à proximité de laquelle se trouve l'extrémité du balai frottant contre une surface mobile tournante, le courant traversant le balai circule dans trois directions : dans la direction longitudinale, mais aussi dans deux directions d'un plan perpendiculaire à la direction longitudinale. Lorsqu'il est placé dans cette région, le capteur à effet Hall ne mesurera donc pas la totalité du courant.

Aussi, avantageusement, pour une meilleure précision de la mesure, le concentrateur et le capteur à effet Hall peuvent être situés à une position plus proche de l'extrémité distale que de l'extrémité proximale du support de balai suivant la direction longitudinale. En utilisation, le concentrateur et le capteur à effet Hall sont alors situés à une position plus proche de l'extrémité du balai frottant contre une surface mobile tournante. Dans cette région du balai, le courant circule suivant une direction essentiellement longitudinale, de sorte que la totalité ou quasi-totalité du courant traversant le balai peut être mesurée. Notamment, le concentrateur et le capteur à effet Hall peuvent être situés au niveau de l'extrémité distale du support de balai.

Le concentrateur peut entourer entièrement un balai reçu dans le logement du support de balai dans un plan perpendiculaire à la direction longitudinale ou présenter une forme ouverte.

Avantageusement, le logement peut présenter une section en forme de quadrilatère dans un plan s'étendant perpendiculairement à la direction longitudinale du support de balai, le concentrateur peut alors entourer un balai reçu à l'intérieur du logement sur au moins trois côtés de la forme de quadrilatère du logement dans ce même plan, voire partiellement ou totalement sur le quatrième côté logement. Une telle forme du concentrateur est simple à réaliser et permet une concentration particulièrement efficace du champ magnétique créé par le courant traversant le balai tout en limitant les perturbations provenant d'un champ magnétique généré par des balais adjacents et/ou provenant de sources externes. Le concentrateur peut notamment présenter une forme de U, le capteur étant avantageusement positionné entre les ailes du U, notamment à mi-distance de celles-ci, du côté de l'ouverture du U.

De manière générale, le concentrateur peut épouser la forme du support de balai et être appliqué contre des parois formant celui-ci, à l'extérieur ou à l'intérieur du support de balai.

Avantageusement, le capteur à effet Hall peut être fixé sur un support de capteur situé à l'intérieur d'un boîtier monté sur le support de balai de sorte que le capteur à effet Hall est monté de manière amovible sur le support de balai. Ce montage amovible du capteur à effet Hall peut résulter d'un montage amovible du boîtier sur le support de balai, du support de capteur sur le boîtier, ou les deux. Le capteur à effet Hall peut ainsi être facilement monté/démonté du support de balai, ce qui permet une installation, voire un remplacement, facile et rapide. Par exemple, le boîtier recevant le support de capteur peut être fixé par encliquetage sur le support de balai ou encore, le support de capteur peut être inséré à la manière d'une cartouche à l'intérieur du boîtier.

Ainsi, au moins un élément choisi parmi le boîtier et le support de capteur peut être monté de manière amovible, notamment sans outils. Ce montage amovible peut par exemple être réalisé au moyen d'organes mâles ou femelles coopérant avec des organes femelles/mâles correspondants du support de balai ou du boîtier. Ces organes mâles/femelles correspondants peuvent par exemple être choisis parmi un rail/doigt de coulissement, orifice/doigt d'encliquetage, orifice/patte d'encliquetage, d'autres types d'organes mâles/femelles de type coulisse/rails ou autres, et leurs combinaisons.

En variante, le capteur à effet Hall pourrait être monté de manière fixe (non démontable) sur le support de balai, soit directement (par collage ou autre), soit via un support de capteur monté de manière fixe sur le support de balai (par collage, vissage ou autre), ou via un support de capteur situé à l'intérieur d'un boîtier monté de manière fixe sur le support de balai (par collage, vissage ou autre).

De manière générale, le support de capteur peut s'étendre parallèlement à la direction longitudinale, de préférence parallèlement à une face du support de balai.

Avantageusement, le support de capteur peut être ou comprendre une carte de circuit imprimé. Le support de capteur se présente alors sous la forme d'une plaque portant des composants électroniques. Le capteur à effet Hall peut alors être fixé à la face de la carte de circuit imprimé portant les composants électroniques et positionnée en regard du support de balai. Cette carte de circuit imprimée peut, par exemple, être insérée par coulissement à l'intérieur du boîtier monté sur le porte balai.

Avantageusement, la carte de circuit imprimé peut alors comprendre au moins un microprocesseur ou microcontrôleur pour analyser les données fournies par le capteur à effet Hall. Le dispositif capteur de courant peut alors comprendre en outre un organe de connexion conformé pour collecter et transmettre à un système de gestion des données les données analysées par l'au moins un microprocesseur ou microcontrôleur.

Avantageusement, pour faciliter le montage du concentrateur, celui-ci peut également être monté de préférence sans outils et/ou de manière amovible sur le support de balai. Par exemple, le concentrateur peut être fixé au support de balai au moyen d'un élément de support fixé au support de balai, notamment sans outils et/ou de manière amovible. Cet élément de support peut également être conformé pour protéger le concentrateur.

Pour un montage rapide, le dispositif de capteur de courant peut comprendre au moins une des caractéristiques suivantes :
- le support de balai peut définir au moins un organe de retenue coopérant avec un organe de retenue d'au moins un élément choisi parmi le boîtier, le concentrateur, l'élément de support,
- le boîtier peut définir au moins un organe de retenue coopérant avec un organe de retenue d'au moins un élément choisi parmi le concentrateur et l'élément de support,
- l'élément de support peut définir au moins un organe de retenue coopérant avec un organe de retenue d'au moins un élément choisi parmi le support de balai, le boîtier et le concentrateur.

Notamment, ces organes de retenue peuvent être conformés pour bloquer un mouvement relatif des pièces qu'elles retiennent au moins suivant la direction longitudinale, voire dans toutes les directions de l'espace.

Ces organes de retenue peuvent être choisis parmi une butée, un logement, un orifice, un organe mâle et un organe femelle, coopérant respectivement avec un bord ou une saillie, une partie d'élément, un organe femelle et un organe mâle. Les organes mâles peuvent comprendre un doigt, une patte, une languette, une vis, un pointeau ou similaire. Les organes femelles peuvent comprendre un orifice, une fente, un rail ou similaire.

Avantageusement, la longueur du concentrateur suivant la direction longitudinale représente 50% ou moins de la longueur du support de balai, optionnellement depuis l'extrémité distale du support de balai, notamment 40% ou moins, 30% ou moins ou 25% ou moins.

Avantageusement, pour une meilleure efficacité du concentrateur, la longueur du concentrateur suivant la direction longitudinale peut être égale ou supérieure à la longueur correspondante du capteur à effet Hall, de préférence au moins égale à cette longueur. Optionnellement, pour une efficacité optimale, le capteur à effet Hall peut être à une position située dans au moins un plan médian par rapport au concentrateur, ce plan médian étant choisi parmi un plan médian parallèle à la direction longitudinale et un plan médian perpendiculaire à cette dernière.

Les fonctions de concentration des champs magnétiques et de protection du concentrateur pourront être obtenues par tout matériau approprié, notamment ferromagnétique, ce matériau pouvant éventuellement présenter une structure particulière, par exemple une structure laminée ou toute autre structure adaptée.

Avantageusement, le concentrateur peut être en matériau ferromagnétique.

Avantageusement, le dispositif capteur de courant peut comprendre au moins un autre capteur conformé pour mesurer au moins un paramètre associé à l'état du balai. Ce paramètre est par exemple choisi parmi un paramètre caractéristique de l'usure du balai, la température du balai, un paramètre représentatif des vibrations subies par le balai, un paramètre représentatif d'une chute de tension entre le balai et la surface mobile tournante. Le ou les capteurs supplémentaires peuvent être solidaires du support de balai, du support de capteur ou du boîtier recevant le support de capteur.

L'invention concerne également un ensemble comprenant un dispositif capteur de courant tel que précédent décrit et un balai reçu de manière coulissante suivant la direction longitudinale à l'intérieur du logement du support de balai de sorte qu'une extrémité du balai destinée à frotter contre une surface mobile tournante, fasse saillie du support de balai du côté de son extrémité distale.

L'invention a aussi pour objet une machine électrique tournante comprenant au moins un dispositif capteur de courant selon l'invention.

En particulier, la machine électrique tournante peut comprendre une pluralité de balais et chaque balai est reçu à l'intérieur du logement du support de balai d'un dispositif de capteur de courant, de manière coulissante suivant la direction longitudinale de sorte qu'une extrémité du balai destinée à frotter contre une surface mobile tournante de la machine électrique, fasse saillie du support de balai du côté de son extrémité distale.

L'invention concerne également un procédé d'assemblage d'un dispositif capteur de courant pour surveiller le courant d'un balai, notamment tel que décrit précédemment, comprenant :
- prévoir un support de balai s'étendant suivant une direction longitudinale entre des extrémités distale et proximale, et définissant un logement traversant destiné à recevoir de manière coulissante suivant la direction longitudinale un balai de sorte qu'une extrémité du balai destinée à frotter contre une surface mobile tournante, fasse saillie du porte-balai du côté de son extrémité distale,
- monter un concentrateur, conformé pour concentrer les champs magnétiques à l'intérieur d'une zone de champ magnétique concentré et pour protéger cette zone des champs magnétiques externes, sur le support de balai de manière à entourer au moins une partie du balai lorsque ce dernier est reçu à l'intérieur du logement du support de balai, notamment dans un plan perpendiculaire à la direction longitudinale, de sorte que le champ magnétique généré par le flux de courant traversant le balai reçu dans le logement du support de balai soit concentré par le concentrateur dans une zone de champ magnétique concentré,
- monter sur le support de balai un capteur à effet Hall conformé pour détecter un champ magnétique, à une position située à l'intérieur de la zone de champ magnétique concentré, de manière à mesurer une valeur représentative de l'intensité du courant traversant le balai.

Notamment, l'invention n'est pas limitée à un ordre particulier des étapes de montage du concentrateur et du capteur à effet Hall.

Avantageusement, le montage du capteur à effet Hall peut comprendre :
- la fixation du capteur à effet Hall sur un support de capteur,
- le montage du support de capteur à l'intérieur d'un boîtier,
- le montage du boîtier sur le support de balai.
En particulier, le montage du support de capteur à l'intérieur du boîtier peut être sans outils et/ou amovible, et/ou le montage du boîtier sur le support de balai peut être sans outils et/ou amovible.

L'invention est maintenant décrite en référence aux dessins annexés, non limitatifs, dans lesquels :
La figure 1 une vue en perspective d'un dispositif capteur de courant selon un mode de réalisation recevant un balai.
La figure 2 est une vue en perspective éclatée des éléments montés sur le support de balai du dispositif capteur de courant de la figure 1.
La figure 3 est une vue en coupe schématique d'une extrémité du dispositif de capteur de courant de la figure 1.
La figure 4 est une vue en coupe latérale d'un concentrateur et du capteur à effet Hall.
La figure 5 est une vue en perspective du support de balai du dispositif capteur de courant de la figure 1.
La figure 6 est une vue similaire à la figure 5, représentant de plus un boîtier en position de pré montage et un concentrateur.
La figure 7 est une vue similaire à la figure 6 après mise en place du concentrateur et de son élément de support.
La figure 8 est une vue similaire à la figure 7, le boîtier étant dans une position montée.
La figure 9 représente schématiquement une machine tournante et l'architecture électronique de commande des dispositifs de capteur de courant montés sur la machine tournante.
La figure 10 est une vue en perspective du support de balai du dispositif capteur de courant selon une variante de réalisation.
La figure 11 est une vue similaire à la figure 10, représentant de plus un boîtier en position de pré montage.
La figure 12 est une vue similaire à la figure 11, après mise en place du concentrateur et de son élément de support, le boîtier étant dans une position montée.

Sur les figures, le repère X, Y, Z est un repère orthonormé.

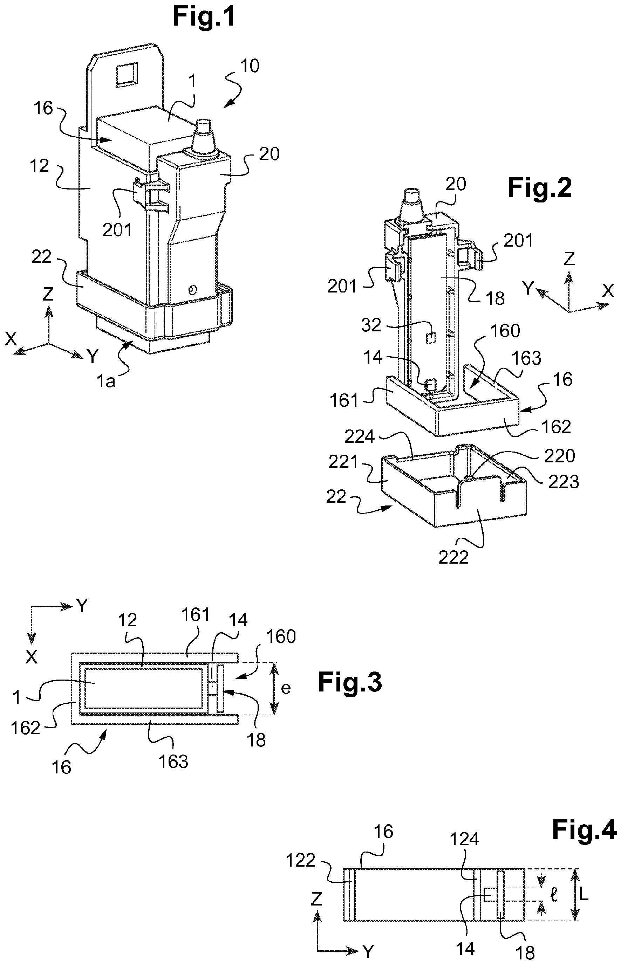

En références aux figures 1 à 8, on décrit un dispositif capteur de courant 10 pour surveiller le courant traversant un balai 1 selon un mode de réalisation de l'invention.

Ce dispositif capteur de courant 10 comprend :
- un support de balai 12,
- un capteur à effet Hall 14 conformé pour détecter un champ magnétique,
- un concentrateur 16 conformé pour concentrer les champs magnétiques à l'intérieur d'une zone de champ magnétique concentré et pour protéger cette zone des champs magnétiques externes.

Le support de balai 12 s'étend suivant une direction longitudinale (correspondant à l'axe z des figures) entre des extrémités distale 12a et proximale 12b. Le support de balai 12 définit un logement 120 traversant destiné à recevoir de manière coulissante suivant la direction longitudinale le balai 1, de sorte qu'une extrémité distale 1a du balai destinée à frotter contre une surface mobile tournante, fasse saillie du support de balai 12 du côté de son extrémité distale 12a, tel que représenté figure 1. Le logement 120 s'étend ainsi également suivant la direction longitudinale z. De manière générale, la direction longitudinale du support de balai 12 est confondue avec la direction longitudinale d'un balai 12 reçu à l'intérieur du logement 120.

En général, l'extrémité distale 1a du balai 1 fait saillie de l'extrémité distale 12a du support de balai 12 suivant cette direction longitudinale z de quelques millimètres. De manière classique, le support de balai 12 est réalisé en un matériau thermiquement conducteur et présentant une bonne résistance mécanique, tel que du laiton, un acier inoxydable, un alliage cuivre aluminium ou tout autre matériau approprié.

Habituellement, le balai 1 présente une forme parallélépipédique, de même que le logement 120 qui le reçoit. Le logement 120 est en général défini par des parois du support de balai, ici quatre parois 121, 122, 123, 124, s'étendant parallèlement à la direction longitudinale z.

Selon l'invention, le concentrateur 16 est monté sur le support de balai 12 de manière à entourer au moins une partie du balai 1 lorsque ce dernier est reçu dans le support de balai 12 de sorte que le champ magnétique généré par le flux de courant traversant le balai soit concentré par le concentrateur dans une zone 160 de champ concentré. Cette zone 160 de champ concentré correspond notamment à une zone située entre des parois formant le concentrateur. Ainsi, le concentrateur 16 entoure au moins en partie le logement 120 défini par le support de balai 12, en particulier dans un plan perpendiculaire à la direction longitudinale z du support de balai 12.

Dans le mode de réalisation représenté, le concentrateur 16 présente une forme de U dans un plan s'étendant perpendiculairement à la direction longitudinale du support de balai. Il est ainsi formé de trois parois 161, 162, 163 s'étendant parallèlement à la direction longitudinale z, dont deux parois 161, 163 formant les ailes de la forme en U sont parallèles entre elles et reliées par la troisième paroi 162. Le concentrateur 16 entoure ainsi trois des quatre faces du support de balai, la zone de champ concentrée 160 s'étendant entre les trois parois 161-163. Le concentrateur 16 est par exemple formé à partir d'une plaque de matériau de forme rectangulaire pliée en U.

Cette forme en U présente l'avantage d'être simple à réaliser et à assembler au support de balai. L'invention n'est toutefois pas limitée à ce mode de réalisation. On pourrait notamment envisager un concentrateur entourant entièrement le support de balai dans un plan perpendiculaire à la direction longitudinale ou un concentrateur en forme de U dont les extrémités libres des ailes sont recourbées l'une vers l'autre parallèlement à la paroi 124 présentant ainsi une forme similaire à un C.

Le concentrateur 16 est de manière usuelle réalisé en matériau ferromagnétique. Des matériaux ferromagnétiques envisageables sont le fer, le nickel, SiFe, NiFe, ou tout autre matériau ferromagnétique. Le concentrateur peut par exemple être formé d'une feuille métallique ou d'une superposition de feuilles métalliques. Il peut par exemple être formé de plusieurs feuilles de fer et de nickel laminées.

L'homme du métier saura déterminer de manière usuelle l'épaisseur du concentrateur en fonction de l'amplitude du courant traversant le balai.

De manière générale, il est préférable que le concentrateur 16 soit en appui contre le support de balai, par exemple appliqué contre les parois 121-124 du support de balai définissant le logement 120 à l'extérieur du support de balai. L'espace entre le support de balai et le concentrateur est ainsi réduit au minimum, ce qui permet de positionner le concentrateur au plus près du capteur à effet Hall et d'améliorer la concentration du champ magnétique. L'homme du métier pourra prévoir un jeu de montage entre le concentrateur et le support de balai. Dans un mode de réalisation non représenté, le concentrateur pourrait être en appui contre les parois 121-124 du support de balai définissant le logement 120 à l'intérieur du support de balai. Le concentrateur définit alors au moins partiellement le logement 120.

Selon l'invention, le capteur à effet Hall 14 est monté sur le support de balai 12 à une position située à l'intérieur de la zone 160 de champ magnétique concentré, de manière à mesurer une valeur représentative de l'intensité du courant traversant le balai 1.

Un capteur à effet Hall est sensible au champ magnétique généré par une circulation de courant électrique. Il convertit le champ magnétique généré en une tension proportionnelle à ce champ. La sortie du capteur peut être linéaire au champ magnétique, et parce que le champ est linéaire au courant dans le conducteur, la tension de sortie fournira une tension linéaire qui est directement proportionnelle au courant. Pour les capteurs à sortie non linéaire, le courant pourra être déterminé par un abaque ou une équation, par exemple intégrés à un microprocesseur ou microcontrôleur. Le fonctionnement de ce type de capteur est bien connu et ne sera pas davantage détaillé.

Les capteurs à effet Hall conventionnels détectent un flux magnétique perpendiculairement à leur surface, ce qui ne permet pas de les monter très proches du conducteur dans lequel circule le courant à mesurer.

Bien que de tels capteurs soient envisageables dans la présente invention, ils sont relativement encombrants et peu sensibles. On préfèrera utiliser un capteur à effet Hall sensible à un champ magnétique s'étendant parallèlement à sa surface. Ce type de capteur à effet Hall est plus sensible que les capteurs à effet Hall conventionnels et peut être monté au plus près du conducteur dans lequel circule le courant à mesurer, améliorant ainsi la sensibilité du capteur. On pourra avantageusement utiliser des capteurs à effet Hall comprenant un concentrateur magnétique intégré, autrement dit, les capteurs à effet Hall utilisant la technologie IMC-Hall^{®} (Integrated Magneto-Concentrator). Un capteur de ce type est fabriqué au moyen de la technologie CMOS standard, avec une couche ferromagnetique supplémentaire caractérisée par une forte perméabilité et un champ coercitif faible (très doux) qui joue le rôle d'un concentrateur de champ magnétique. Ce type de capteur présente aussi l'avantage de permettre de mesurer des courants alternatifs ou continus.

Afin d'améliorer la précision de la mesure, le concentrateur 16 et le capteur à effet Hall 14 sont avantageusement situés à une position plus proche de l'extrémité distale 12a que de l'extrémité proximale 12b du support de balai 12. Dans un mode de réalisation préféré, tel que représenté sur les figures, le concentrateur 16 est fixé au niveau de l'extrémité distale 12a du support de balai 12, par exemple le long du bord des parois 121-123 du support de balai définissant le logement 120.

De manière générale, avantageusement, la partie du support de balai 12 entourée par le concentrateur 16 s'étend suivant la direction longitudinale sur une longueur L qui représente 50% ou moins de la longueur du support de balai, notamment depuis l'extrémité distale 12a du porte balai 12. Cette longueur L correspond à la dimension du concentrateur 16 suivant la direction longitudinale z. Toutefois, avantageusement, la longueur L du concentrateur 16 suivant la direction longitudinale est au moins égale à la longueur **ℓ** du capteur à effet Hall 14, de préférence supérieure à celle-ci, par exemple 1,5 à 3 fois supérieure à la longueur du capteur 14. La longueur L du concentrateur peut ainsi être choisie dans des intervalles dont la valeur minimale est telle que précédemment définie et la valeur maximale représente 50%, 40%, 30%, 25% ou moins de la longueur du support de balai.

On positionnera de préférence le capteur 14 à l'intérieur de la zone de de champ magnétique concentré dans une position médiane par rapport au concentrateur dans un plan perpendiculaire à la direction longitudinale et dans un plan parallèle à la direction longitudinale. Autrement dit, tel que visible sur les figures 3 et 4, le capteur à effet Hall est situé à mi distance de l'écartement e entre les parois 161, 163 du concentrateur et à mi longueur du concentrateur suivant la direction longitudinale z.

Dans le mode de réalisation représenté, on notera que le capteur à effet Hall 14 est situé entre les ailes de la forme en U, du côté de son ouverture, à faible distance de celle-ci. Le capteur à effet Hall pourrait être positionné plus près de l'ouverture, pourvu que le capteur reste à l'intérieur de la zone 160 définie par les parois 161-163 du concentrateur. On positionnera de préférence le capteur à effet Hall au plus près du support de balai 12 pour une meilleure précision de mesure, un jeu de montage pouvant toutefois être prévu entre le support de balai 12 et le capteur à effet Hall.

Dans les exemples représentés figures 1 à 8 et 10 à 12, le capteur à effet Hall 14 est fixé sur un support de capteur 18 situé à l'intérieur d'un boîtier 20 monté sur le support de balai 12. Le boîtier 20 permet de protéger le capteur à effet Hall 14, voire le support de capteur 18 de l'environnement externe. Le montage est effectué de sorte que le capteur à effet Hall soit monté de manière amovible sur le support de balai.

Dans l'exemple représenté sur les figures 1 à 8, le capteur à effet Hall 14 est fixé au support de capteur 18 lequel est fixé au boîtier 20, ce dernier étant emboîté sur le support de balai 12 au moyen de pattes 201 venant s'insérer dans des orifices 125 correspondants du support de balai. Ces pattes 201 viennent en prise sur des parois opposées du support de balai 12. Les pattes 201 et les orifices 125 forment ainsi des organes de retenue au sens de l'invention.

Le support de capteur 18 est quant à lui monté à l'intérieur du boîtier 20, par exemple par insertion, emboîtement, surmoulage, collage ou une combinaison de ces moyens. En particulier, un surmoulage présente l'avantage de mieux protéger le capteur 14 et le support de capteur 18 de l'environnement externe au boîtier 20.

On notera que la face du boitier 20 assemblée au support de balai n'est pas fermée, le boîtier est ainsi en forme de demi-coque. Ainsi, le support de capteur 18 est situé en regard de la paroi 124 du support de balai lorsque le boîtier est monté sur le support de balai, cette paroi 124 fermant le boîtier 20.

La présente invention n'est pas limitée à ce mode de fixation amovible du boîtier 20 au support de balai 12 et tout autre moyen d'emboîtement, amovible ou non, fonctionnant par coopération d'organes mâles et femelles pourrait être envisagé. Le boîtier pourrait ainsi être monté coulissant sur le support de balai ou à la fois monté coulissant avec des parties emboîtées sur le support de balai par mise en prise de doigts ou pattes avec des orifices de forme correspondante. On pourrait également envisager un montage amovible du support de capteur à l'intérieur du boîtier par emboîtement par coulissement et/ou encliquetage.

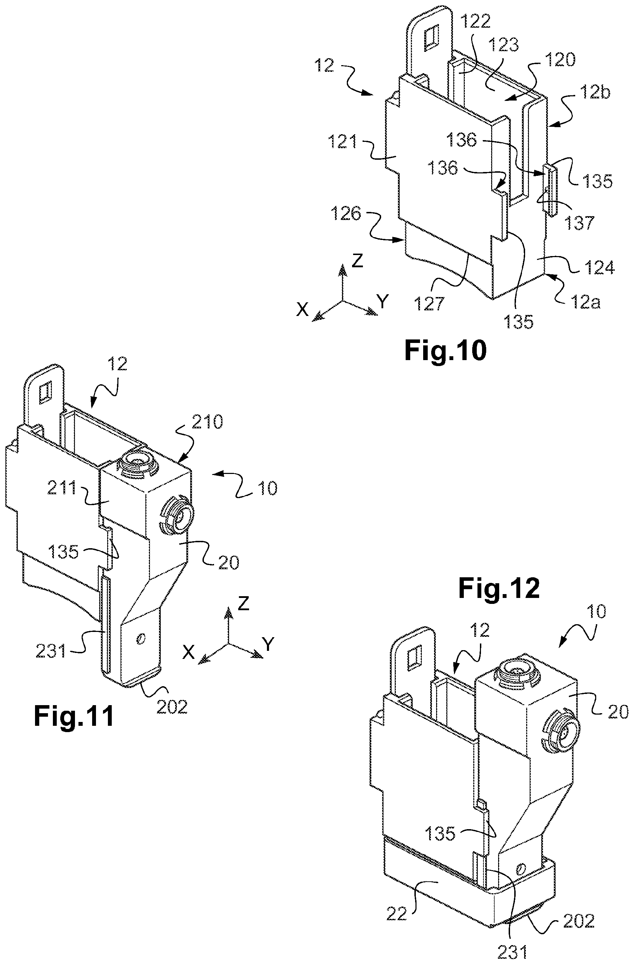

Ainsi, les figures 10 à 12 représentent un mode de réalisation qui ne diffère du mode de réalisation des figures 1-8 que par le mode de fixation amovible du boîtier 20 au support de balai 12, aussi, les mêmes éléments seront désignés par les mêmes références. Dans ce mode de réalisation, le support de balai 12 présente, sur sa paroi 124, deux guides 135 situés en regard l'un de l'autre et présentant une forme de L en section transversale (fig. 10). Dit autrement, ces guides 135 définissent chacun une rainure ou fente 136 avec la paroi 124 formant ainsi un rail de guidage avec celle-ci. Ces guides 135 s'étendent suivant la direction longitudinale z sur une partie de la hauteur du support de balai 12. Le boîtier 20 présente quant-à-lui sur des faces opposées 210, 211 deux pièces de guidage 231 en saillie s'étendant également parallèlement à la direction z et reçues en translation à l'intérieur de chaque guide 135 à la manière de coulisseaux. Dans l'exemple représenté, ces pièces de guidage 231 se présentent sous la forme de languettes. En outre, les pièces de guidage 231 ne s'étendent pas sur toute la hauteur du boîtier 20, facilitant le montage. L'invention n'est toutefois pas limitée par la forme ou la longueur des guides et pièces de guidage pourvu qu'ils puissent coopérer l'un avec l'autre, ici en translation. Les pièces de guidage et les guides forment ainsi des organes de retenue, respectivement de type mâles et femelles, au sens de l'invention. Ces organes de retenue coopèrent, ici par coulissement, pour réaliser un montage amovible.

On notera que les guides 135 pourraient être solidaires du boîtier 20 et les pièces de guidage 231 solidaires du support de balai.

On pourra en outre prévoir des organes de retenue bloquant tout mouvement de translation entre le boîtier 20 et le support de balai 12. Il peut s'agir d'une vis ou plusieurs vis insérées suivant une direction perpendiculaire à la direction de translation, par exemple au travers d'au moins un des guides et/ou pièces de guidage. Cette vis peut simplement venir en appui serré contre le boîtier 20, ou une languette 231, ou encore être insérée dans un orifice du boîtier 20, par exemple une simple fente (ou discontinuité) prévue dans une pièce de guidage, ou un orifice circulaire 137 traversant un guide 135 (fig.10). Il pourra s'agir d'une vis présentant une tête de vis standard, par exemple compatible avec un tournevis plat ou cruciforme, ou présentant une forme spécifique coopérant avec un tournevis spécifique. On pourra éventuellement prévoir d'ajouter un point de colle pour éviter à la vis de se dévisser en présence de vibrations. Les organes de retenue peuvent également être du type pointeau maintenu en position de blocage à l'intérieur d'un orifice par un ressort. Ce type d'organe de retenue peut être actionné par un mécanisme quart tournant.

Enfin, on pourra combiner les modes de réalisation des figures 10 à 12 avec celui des figures 1 à 8.

Le concentrateur 16 est maintenu sur le support de balai 12 au moyen d'un élément de support 22. Celui-ci sert à la fois de support et de protection au concentrateur 16. Dans les exemples, il se présente sous la forme d'un cadre défini par des parois 221, 222, 223, 224 entourant entièrement le support de balai 12 dans un plan perpendiculaire à la direction longitudinale, ces parois s'étendant parallèlement à la direction longitudinale z. Il entoure également le concentrateur 16 et le boîtier 20. Pour un bon maintien et un encombrement minimal, l'élément de support 22 épouse la forme externe du support de balai 12 équipé du concentrateur et du boîtier. La longueur de l'élément de support 22 suivant la direction longitudinale est de préférence au moins égale à la longueur L du concentrateur pour une meilleure protection, mais une dimension inférieure est envisageable, pourvu que l'élément de support 22 puisse assurer le maintien du concentrateur 16. L'élément de support 22, comme le boîtier 20, est de préférence en matériau polymère. L'élément de support 22 comprend des butées internes 220 pour retenir le concentrateur suivant la direction longitudinale z. Ces butées font ainsi saillie du cadre perpendiculairement à la direction longitudinale z, d'une longueur correspondant au plus à la dimension correspondante du concentrateur. De cette manière, ces butées ne font pas saillie à l'intérieur du logement 120 du support de balai lorsque l'élément de support est monté sur celui-ci et ne gênent pas le coulissement du balai 1 à l'intérieur du logement.

Dans un mode de réalisation préféré, le concentrateur 16 est également monté de manière amovible sur le support de balai 12, tel que dans l'exemple représenté. A cet effet, il est monté à l'intérieur de l'élément de support 22 lequel est fixé au support de balai 12 de manière amovible.

Ce montage amovible peut être obtenu par coopération d'organes de retenue entre le support de balai 12 et le concentrateur 16 et/ou son élément de support 22, entre le boîtier 20 et le concentrateur 16 et/ou son élément de support 22, entre l'élément de support 22 et le boîtier 20, le support de balai 12, le concentrateur 16 ou deux ou trois de ces éléments.

Ces organes de retenue peuvent être choisis parmi une butée ou saillie coopérant avec un bord, une languette ou similaire d'un autre élément, un logement ou renfoncement recevant une partie ou la totalité d'un autre élément et un organe mâle tel qu'un doigt ou une patte, coopérant avec un organe femelle tel qu'un orifice ou un rail.

Ainsi, dans l'exemple, le support de balai 12 présente à son extrémité distale 12a un logement 126 du côté externe de ses parois 121-123 recevant le concentrateur 16: ce dernier peut être enfilé sur le support de balai 12 suivant la direction longitudinale z jusqu'au bout du logement 126. Le boîtier 20 présente à son extrémité une butée 202 (ici un rebord) coopérant avec un bord de l'élément de support 22, ici avec un bord de sa paroi 224.

Dans les exemples décrits, le boîtier 20 peut ainsi être facilement monté, notamment sans outils, sur le support de balai 12, et de manière réversible. Ceci peut permettre d'équiper un support de balai et/ou de remplacer un boîtier défectueux après une mise en fonctionnement. On pourrait toutefois envisager un montage fixe du boîtier sur le support de balai bien que cela ne soit pas préféré, voire intégrer le boîtier au support de balai ou intégrer le support de capteur directement au support de balai.

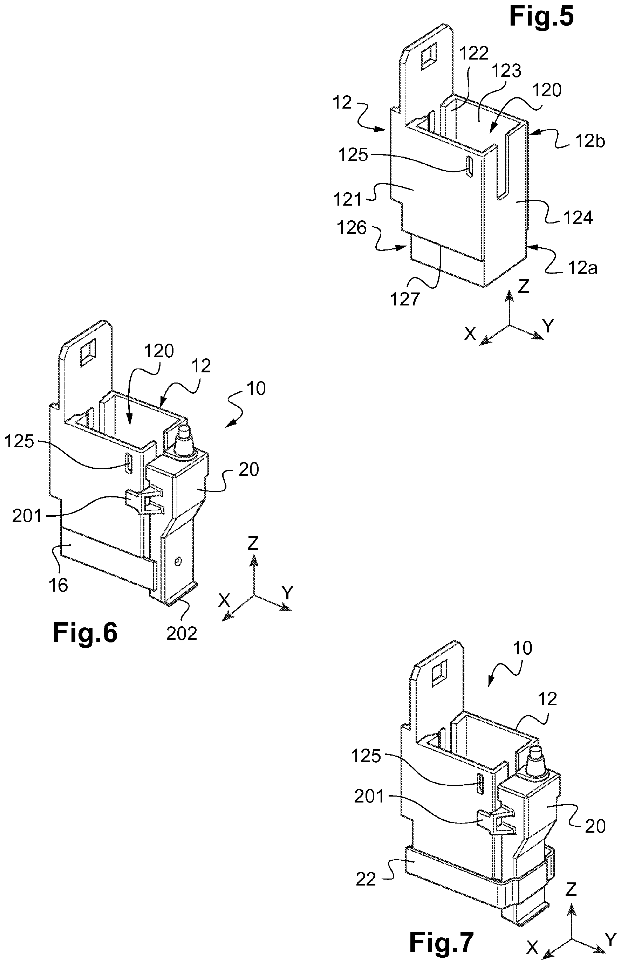

L'assemblage d'un dispositif capteur de courant pour surveiller le courant d'un balai est maintenant décrit en référence aux figures 5 à 8 et 10 à 12. On prévoit tout d'abord un support de balai 12 tel que précédemment décrit.

On vient ensuite monter le capteur à effet Hall 14 sur le support de balai 12. A cet effet, on commence par fixer le capteur à effet Hall 14 sur le support de capteur 18, puis, on monte le support de capteur 18 à l'intérieur du boîtier 20. Le support de capteur 18 peut être maintenu dans le boîtier par emboitement, par coulissement et/ou encliquetage et/ou au moyen d'un matériau polymère le recouvrant en totalité ou en partie. Le boîtier 20 ainsi équipé est ensuite fixé au support de balai 12. Dans l'exemple, il est tout d'abord maintenu dans une position de pré montage représentée figure 6 ou 11, dans laquelle il est en appui contre la paroi 124 du boîtier dans une position permettant la mise en place de l'élément de support 22 du concentrateur 16 autour du boîtier et du support de balai 12. Dans les exemples, il s'agit d'une position (fig. 6) dans laquelle les pattes 201 du boîtier 20 sont situées en dessous suivant la direction z des orifices 125 du support de balai dans lesquelles elles doivent être insérées ou d'une position (fig. 11) dans laquelle les pièces de guidage 231 du boîtier 20 sont situées en dessous suivant la direction z des guides 135 du support de balai dans lesquelles elles doivent être insérées.

On monte ensuite le concentrateur 16 sur le support de balai 12 de manière à entourer au moins une partie d'un balai inséré dans le logement 120 du support de balai (voir fig.6). A cet effet, le concentrateur en U est enfilé sur le support de balai 12 par l'extrémité distale 12a de celui-ci suivant la direction longitudinale z. Ici, le concentrateur 16 est reçu dans le logement 126 ménagé sur la face externe des parois 121-123 du support de balai 12 et vient en butée contre le fond de ce logement (décrochement 127 visible figure 5). L'élément de support 22 peut alors être mis en position : il est d'abord incliné pour passer la butée 202 du boîtier puis redressé afin de pouvoir être enfilé suivant la direction longitudinale sur le concentrateur et le boîtier 20, tel que représenté figure 7.

Alternativement, pour un montage plus simple, le concentrateur 16 peut être positionné à l'intérieur de l'élément de support 22 puis ce dernier positionné autour du support de balai 12 et du boîtier 20 par inclinaison et déplacement suivant la direction longitudinale z pour arriver au montage de la figure 7, tel que décrit ci-dessus.

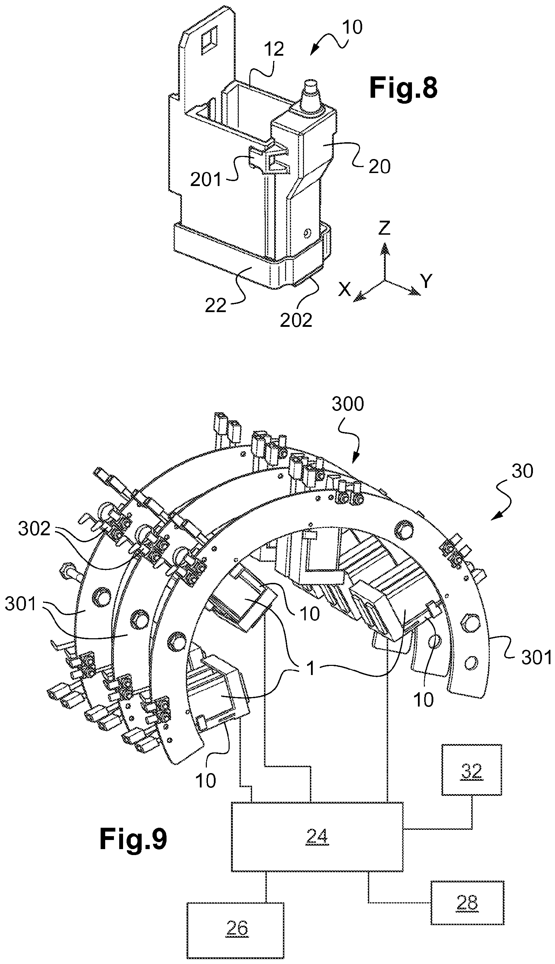

Le boîtier 20 est ensuite déplacé longitudinalement jusqu'à ce que sa butée 202 vienne en prise avec l'élément de support 22, maintenant ce dernier en position suivant la direction longitudinale z (voir figures 8 et 12). Bien entendu, la butée 202 pourrait aussi être prévue sur le support de balai, par exemple sur le bord de sa paroi 122.

Bien entendu, l'invention n'est pas limité à un ordre de montage particulier des différentes pièces, lequel peut différer en fonction de la configuration de ces pièces et des organes de retenue.

Le support de capteur 18 est ici une carte de circuit intégré comprenant au moins un microprocesseur ou microcontrôleur (non représentés) pour analyser les données fournies par le capteur à effet Hall. On positionnera de préférence le support de capteur 18 sur la face de la carte de circuit intégré portant les composants électroniques, cette face étant située en regard du support de balai 12.

Le dispositif capteur de courant 10 comprend alors avantageusement un organe de connexion 24 conformé pour collecter et transmettre à un système de gestion de données 26 les données analysées par l'au moins un microprocesseur ou microcontrôleur. Le microprocesseur ou microcontrôleur effectue notamment un traitement du signal reçu par le capteur à effet Hall, en utilisant par exemple des fonctions mathématiques telles que des moyennes quadratiques (RMS, Root Means Square) et transmet le signal traité à l'organe de connexion 24, lequel va collecter les données reçues du dispositif de capteur de courant 10 auquel il est relié et les transmettre au système de gestion de données 26. Ce dernier peut permettre l'acquisition, le traitement et l'affichage des données reçues. Il peut comprendre un ou plusieurs processeurs et dispositif d'affichage. Il peut s'agir par exemple d'un ordinateur.

Cet organe de connexion 24, par exemple une passerelle (« gateway » en anglais), peut être conformé pour une transmission sans fil ou filaire vers le système de gestion de données 26. L'organe de connexion 24 permet également de relier le dispositif capteur de courant 10 à une alimentation en énergie 28 alimentant le microprocesseur ou microcontrôleur, et éventuellement le capteur à effet Hall. L'organe de connexion 24, le système de gestion de données 26 et l'alimentation en énergie 28 peuvent être communs à une pluralité de dispositifs capteurs de courant d'une machine tournante électrique.

Les dispositifs capteurs de courant décrits 10 peuvent être intégrés à une pièce fixe 300 d'une machine tournante électrique 30. Cette pièce fixe peut être un stator, une bobine fixe, un équipement fixe raccordé électriquement aux câbles de balais, ou autre. La pièce fixe 300, représentée partiellement figure 9, comprend des portions de couronne 301, chaque portion de couronne supportant plusieurs supports de balai 10 et des connecteurs de courant 302. La pièce fixe 300 entoure habituellement une pièce tournante (non représentée) de la machine électrique 30. Cette pièce tournante peut par exemple être un arbre tournant, un collecteur à bague rotatif, ou autre, de même axe que l'axe des portions de couronne 301.

L'invention et ses modes de réalisation présentent les avantages suivants:
1) Le capteur Hall est protégé des sources externes de magnétisme et il n'est pas intrusif, de sorte qu'il mesure le courant à travers le balai avec une grande efficacité;
2) Des courants élevés (amplitude élevée) peuvent être mesurés, avec une réponse linéaire jusqu'à 600A.
3) Lorsque le courant est mesuré à l'extrémité distale, où il circule dans une direction radiale, le courant total à travers la section du balai est mesuré.
4) Le dispositif de capteur de courant est compact.
5) Le dispositif de capteur de courant est également facile à monter / démonter, notamment sans outil.

Avec le dispositif de captage de courant selon l'invention, il est possible de mesurer un courant jusqu'à 600 A, avec un écart de ± 30 A maximum, ce qui correspond à une précision de ± 5%, voire de ± 2%. Des courants plus élevés pourraient être mesurés en augmentant l'épaisseur du concentrateur.

Le dispositif capteur de courant peut en outre inclure un ou plusieurs autres capteurs 32 (représenté schématiquement figures 2 et 9) permettant de mesurer au moins un paramètre associé à l'état du balai. On peut ainsi surveiller en temps réel les performances complètes d'un balai.

Ce paramètre peut être choisi parmi un paramètre caractéristique de l'usure du balai, par exemple une longueur de balai ou une position de balai, la température du balai, un paramètre représentatif des vibrations subies par le balai, un paramètre représentatif d'une chute de tension entre le balai et la surface mobile tournante.

L'usure du balai peut être déterminée au moyen d'un capteur de position tel qu'un contact Reed. Un contact Reed (ou interrupteur Reed ou interrupteur à lames souples) est un interrupteur magnétique comprenant deux lames en matériau magnétique scellées à l'intérieur d'un tube de verre contenant un gaz neutre. Les lames sont disposées avec un léger recouvrement au niveau des contacts à l'intérieur du verre, espacées de quelques centièmes de millimètre entre elles (entrefer). Lorsque l'interrupteur est placé dans un champ magnétique, les lames s'aimantent par influence et s'attirent mutuellement jusqu'au contact. La suppression du champ magnétique provoque la séparation des lames. Le champ magnétique peut être produit par l'approche d'un aimant solidaire du balai. Cet aimant peut être situé à une extrémité du balai ou à toute autre position à l'intérieur du balai correspondant à une position d'usure particulière.

L'usure du balai peut également être déterminée au moyen d'un capteur de position tel qu'un capteur à effet Hall, interagissant au moyen d'un champ magnétique ou par induction avec un élément tel qu'un aimant ou un réacteur inductif disposé à l'intérieur du balai.

De tels capteurs de position peuvent être fixés sur le support de balai ou sur le support de capteur.

Les vibrations peuvent être détectées au moyen d'un accéléromètre, fixé au balai, au support de balai, au support de capteur ou sur un système de pression venant en appui sur le balai afin de le maintenir en contact avec la surface mobile tournante.

La chute de tension entre le balai et la surface mobile tournante peut être détectée au moyen au moyen de 2 câbles reliés à un voltmètre.

Le capteur de température, par exemple un thermocouple, pourra également être fixé au support de balai ou support de capteur.

Chacun de ces capteurs est avantageusement connecté au système de gestion des données, notamment via l'organe de connexion.

## Revendications

1. Dispositif capteur de courant (10) pour surveiller le courant traversant un balai (1) comprenant :
- un support de balai (12) s'étendant suivant une direction longitudinale entre des extrémités distale (12a) et proximale (12b), et définissant un logement (120) traversant destiné à recevoir de manière coulissante suivant la direction longitudinale un balai de sorte qu'une extrémité du balai destinée à frotter contre une surface mobile tournante, fasse saillie du support de balai du côté de son extrémité distale,
- un capteur à effet Hall (14) conformé pour détecter un champ magnétique,
le dispositif de capteur de courant étant **caractérisé par** :
- un concentrateur (16) conformé pour concentrer les champs magnétiques à l'intérieur d'une zone (160) de champ magnétique concentré et pour protéger cette zone des champs magnétiques externes, dans lequel,
- le concentrateur (16) est monté sur le support de balai (12) de manière à entourer au moins une partie du balai lorsque ce dernier est reçu à l'intérieur du logement (120) du support de balai, notamment dans un plan perpendiculaire à la direction longitudinale,
- le capteur à effet Hall (14) est monté sur le support de balai (12) à une position située à l'intérieur de la zone (160) de champ magnétique concentré, de manière à mesurer une valeur représentative de l'intensité du courant traversant le balai lorsque ce dernier est reçu dans le logement du support de balai.

2. Dispositif capteur de courant (10) selon la revendication 1, dans lequel le concentrateur (16) et le capteur à effet Hall (14) sont situés à une position plus proche de l'extrémité distale (12a) que de l'extrémité proximale (12b) du support de balai suivant la direction longitudinale.

3. Dispositif capteur de courant (10) selon la revendication 1 ou 2, dans lequel le logement (120) présente une section en forme de quadrilatère dans un plan s'étendant perpendiculairement à la direction longitudinale du support de balai, et le concentrateur (16) entoure le balai lorsque ce dernier est reçu à l'intérieur du logement sur au moins trois côtés de la forme de quadrilatère du logement dans ce même plan.

4. Dispositif capteur de courant (10) selon l'une quelconque des revendications 1 à 3, dans lequel le capteur à effet Hall (14) est fixé sur un support de capteur (18) situé à l'intérieur d'un boîtier (20) monté sur le support de balai (12).

5. Dispositif capteur de courant (10) selon la revendication 4, dans lequel au moins un élément choisi parmi le boîtier et le support de capteur est monté de manière amovible.

6. Dispositif capteur de courant (10) selon la revendication 4 ou 5, dans lequel le support de capteur est, ou comprend, une carte de circuit intégré, celle-ci comprenant au moins un microprocesseur ou microcontrôleur pour analyser les données fournies par le capteur à effet Hall.

7. Dispositif capteur de courant (10) selon la revendication 6, comprenant en outre un organe de connexion conformé pour collecter et transmettre à un système de gestion des données les données analysées par l'au moins un microprocesseur ou microcontrôleur.

8. Dispositif capteur de courant (10) selon l'une quelconque des revendications 1 à 7, dans lequel le concentrateur (16) est fixé au support de balai (12) au moyen d'un élément de support (22) fixé au support de balai.

9. Dispositif capteur de courant (10) selon l'une quelconque des revendications 1 à 8, comprenant au moins une des caractéristiques suivantes :
- le support de balai (12) définit au moins un organe de retenue (125, 126 ; 135) coopérant avec un organe de retenue (201, 161-163 ; 231) d'au moins un élément choisi parmi le concentrateur, le boîtier et l'élément de support,
- le boîtier (20) définit au moins un organe de retenue (202) coopérant avec un organe de retenue (224) d'au moins un élément choisi parmi le concentrateur et l'élément de support,
- l'élément de support (22) définit au moins un organe de retenue (220) coopérant avec un organe de retenue (161-163) d'au moins un élément choisi parmi le support de balai, le concentrateur et le boîtier.

10. Dispositif capteur de courant (10) selon l'une quelconque des revendications 1 à 9, dans lequel la longueur du concentrateur (16) suivant la direction longitudinale représente 50% ou moins de la longueur du support de balai, optionnellement depuis l'extrémité distale du support de balai.

11. Dispositif capteur de courant (10) selon l'une quelconque des revendications 1 à 10, dans lequel la longueur du concentrateur (16) suivant la direction longitudinale est égale ou supérieure à la longueur correspondante du capteur à effet Hall, optionnellement, le capteur est à une position située dans au moins un plan médian par rapport au concentrateur, ce plan médian étant choisi parmi un plan médian parallèle à la direction longitudinale et un plan médian perpendiculaire à cette dernière.

12. Dispositif capteur de courant (10) selon l'une quelconque des revendications 1 à 11, dans lequel le concentrateur (16) est en matériau ferromagnétique.

13. Dispositif capteur de courant (10) selon l'une quelconque des revendications 1 à 12, comprenant au moins un autre capteur conformé pour mesurer au moins un paramètre associé à l'état du balai.

14. Machine électrique tournante (30) comprenant au moins un dispositif capteur de courant (10) selon l'une quelconque des revendications précédentes.

15. Procédé d'assemblage d'un dispositif capteur de courant (10) pour surveiller le courant d'un balai, comprenant :
- prévoir un support de balai s'étendant suivant une direction longitudinale entre des extrémités distale et proximale, et définissant un logement traversant destiné à recevoir de manière coulissante suivant la direction longitudinale un balai de sorte qu'une extrémité du balai destinée à frotter contre une surface mobile tournante, fasse saillie du porte-balai du côté de son extrémité distale,
- monter un concentrateur, conformé pour concentrer les champs magnétiques à l'intérieur d'une zone de champ magnétique concentré et pour protéger cette zone des champs magnétiques externes, sur le support de balai de manière à entourer au moins une partie du balai lorsque ce dernier est reçu à l'intérieur du logement (120) du support de balai, notamment dans un plan perpendiculaire à la direction longitudinale, de sorte que le champ magnétique généré par le flux de courant traversant le balai reçu dans le logement du support de balai soit concentré par le concentrateur dans une zone de champ magnétique concentré,
- monter sur le support de balai un capteur à effet Hall conformé pour détecter un champ magnétique, à une position située à l'intérieur de la zone de champ magnétique concentré, de manière à mesurer une valeur représentative de l'intensité du courant traversant le balai.

16. Procédé d'assemblage selon la revendication 15, dans lequel le montage du capteur à effet Hall comprend :
- la fixation du capteur à effet Hall sur un support de capteur
- le montage du support de capteur à l'intérieur d'un boîtier,
- le montage du boîtier sur le support de balai.

## Patentansprüche

1. Stromsensorvorrichtung (10) zur Überwachung des durch eine Kontaktbürste (1) strömenden Stroms, umfassend:
- einen Kontaktbürstenträger (12), der sich entlang einer Längsrichtung zwischen einem distalen Ende (12a) und einem proximalen Ende (12b) erstreckt und eine quer verlaufende Aufnahme (120) definiert, die dazu bestimmt ist, gleitend entlang der Längsrichtung eine Kontaktbürste so aufzunehmen, dass ein Ende der Kontaktbürste, das dazu bestimmt ist, an einer sich drehenden mobilen Oberfläche zu reiben, vom Kontaktbürstenträger an seinem distalen Ende herausragt,
- einen angeformten Hall-Effekt-Sensor (14) zum Erfassen eines Magnetfelds,
wobei die Stromsensorvorrichtung **gekennzeichnet ist durch**:
- einen angeformten Konzentrator (16) zum Konzentrieren der Magnetfelder im Inneren einer Zone (160) des konzentrierten Magnetfelds und zum Schützen dieser Zone vor externen Magnetfeldern,
wobei,
- der Konzentrator (16) auf dem Kontaktbürstenträger (12) so montiert ist, dass er mindestens einen Teil der Kontaktbürste umgibt, wenn diese im Inneren der Aufnahme (120) des Kontaktbürstenträgers aufgenommen ist, insbesondere in einer zur Längsrichtung senkrechten Ebene,
- der Hall-Effekt-Sensor (14) auf dem Kontaktbürstenträger (12) in einer Position montiert ist, die sich im Inneren der Zone (160) des konzentrierten Magnetfelds befindet, um einen die Intensität des **durch** die Kontaktbürste strömenden Stroms repräsentierenden Wert zu messen, wenn diese in der Aufnahme des Kontaktbürstenträgers aufgenommen ist.

2. Stromsensorvorrichtung (10) nach Anspruch 1, wobei sich der Konzentrator (16) und der Hall-Effekt-Sensor (14) in einer Position befinden, die näher am distalen Ende (12a) als am proximalen Ende (12b) des Kontaktbürstenträgers entlang der Längsrichtung ist.

3. Stromsensorvorrichtung (10) nach Anspruch 1 oder 2, wobei die Aufnahme (120) in einer sich senkrecht zur Längsrichtung des Kontaktbürstenträgers erstreckenden Ebene einen Querschnitt mit viereckiger Form aufweist und der Konzentrator (16) die Kontaktbürste, wenn diese im Inneren der Aufnahme aufgenommen ist, an mindestens drei Seiten der rechteckigen Form der Aufnahme in derselben Ebene umgibt.

4. Stromsensorvorrichtung (10) nach einem der Ansprüche 1 bis 3, wobei der Hall-Effekt-Sensor (14) auf einem Sensorträger (18) befestigt ist, der sich im Inneren eines auf dem Kontaktbürstenträger (12) montierten Gehäuses (20) befindet.

5. Stromsensorvorrichtung (10) nach Anspruch 4, wobei mindestens ein aus dem Gehäuse und dem Sensorträger ausgewähltes Element auf entfernbare Weise montiert ist.

6. Stromsensorvorrichtung (10) nach Anspruch 4 oder 5, wobei der Sensorträger eine integrierte Schaltplatte ist oder umfasst, die mindestens einen Mikroprozessor oder eine Mikrosteuerung zum Analysieren der vom Hall-Effekt-Sensor bereitgestellten Daten umfasst.

7. Stromsensorvorrichtung (10) nach Anspruch 6, ferner umfassend ein angeformtes Anschlusselement zum Erfassen und Übermitteln der vom mindestens einen Mikrosensor bzw. der mindestens einen Mikrosteuerung analysierten Daten an ein Datenverwaltungssystem.

8. Stromsensorvorrichtung (10) nach einem der Ansprüche 1 bis 7, wobei der Konzentrator (16) mittels eines auf dem Kontaktbürstenträger befestigten Trägerelements (22) auf dem Kontaktbürstenträger (12) befestigt ist.

9. Stromsensorvorrichtung (10) nach einem der Ansprüche 1 bis 8, umfassend mindestens eine der folgenden Eigenschaften:
- der Kontaktbürstenträger (12) definiert mindestens ein Halteelement (125, 126; 135), das mit einem Halteelement (201, 161-163; 231) von mindestens einem aus dem Konzentrator, dem Gehäuse und dem Trägerelement ausgewählten Element zusammenwirkt,
- das Gehäuse (20) mindestens ein Haltelement (202) definiert, das mit einem Haltelement (224) von mindestens einem aus dem Konzentrator und dem Trägerelement ausgewählten Element zusammenwirkt,
- das Trägerelement (22) mindestens ein Halteelement (220) definiert, das mit einem Halteelement (161-163) von mindestens einem aus dem Kontaktbürstenträger, dem Konzentrator und dem Gehäuse ausgewählten Element zusammenwirkt.

10. Stromsensorvorrichtung (10) nach einem der Ansprüche 1 bis 9, wobei die Länge des Konzentrators (16) entlang der Längsrichtung 50 % oder weniger der Länge des Kontaktbürstenträgers, optional vom distalen Ende des Kontaktbürstenträgers an, darstellt.

11. Stromsensorvorrichtung (10) nach einem der Ansprüche 1 bis 10, wobei die Länge des Konzentrators (16) entlang der Längsrichtung gleich oder größer als die entsprechende Länge des Hall-Effekt-Sensors ist, optional ist der Sensor in einer Position, die sich in mindestens einer Medianebene bezüglich des Konzentrators befindet, wobei diese Medianebene ausgewählt ist aus einer Medianebene, die parallel zur Längsrichtung ist, und einer Medianebene, die senkrecht zu dieser ist.

12. Stromsensorvorrichtung (10) nach einem der Ansprüche 1 bis 11, wobei der Konzentrator (16) aus einem ferromagnetischen Material besteht.

13. Stromsensorvorrichtung (10) nach einem der Ansprüche 1 bis 12, umfassend mindestens einen weiteren angeformten Sensor zum Messen von mindestens einem dem Zustand der Kontaktbürste zugeordneten Parameter.

14. Rotierende Elektromaschine (30), umfassend mindestens eine Stromsensorvorrichtung (10) nach einem der vorangehenden Ansprüche.

15. Verfahren zum Zusammenfügen einer Stromsensorvorrichtung (10) zur Überwachung des durch eine Kontaktbürste strömenden Stroms, umfassend:
- ein Bereitstellen eines Kontaktbürstenträgers, der sich entlang einer Längsrichtung zwischen einem distalen Ende und einem proximalen Ende erstreckt und eine quer verlaufende Aufnahme definiert, die dazu bestimmt ist, gleitend entlang der Längsrichtung eine Kontaktbürste so aufzunehmen, dass ein Ende der Kontaktbürste, das dazu bestimmt ist, an einer sich drehenden mobilen Oberfläche zu reiben, vom Kontaktbürstenträger an seinem distalen Ende herausragt,
- ein Montieren eines angeformten Konzentrators zum Konzentrieren der Magnetfelder im Inneren einer Zone des konzentrierten Magnetfelds und zum Schützen dieser Zone vor externen Magnetfeldern auf dem Kontaktbürstenträger, so dass mindestens ein Teil der Kontaktbürste umgeben wird, wenn diese im Inneren der Aufnahme (120) des Kontaktbürstenträgers aufgenommen wird, insbesondere in einer zur Längsrichtung senkrechten Ebene, so dass das durch den die in der Aufnahme des Kontaktbürstenträgers aufgenommene Kontaktbürste strömenden Strom erzeugte Magnetfeld durch den Konzentrator in einer Zone des konzentrierten Magnetfelds konzentriert wird,
- ein Montieren eines angeformten Hall-Effekt-Sensors zum Erfassen eines Magnetfelds auf dem Kontaktbürstenträger in einer Position, die sich im Inneren der Zone des konzentrierten Magnetfelds befindet, zum Messen eines die Intensität des durch die Kontaktbürste strömenden Stroms repräsentierenden Werts.

16. Verfahren zum Zusammenfügen nach Anspruch 15, wobei die Montage des Hall-Effekt-Sensors umfasst:
- ein Befestigen des Hall-Effekt-Sensors auf einem Sensorträger,
- ein Montieren des Sensorträgers im Inneren eines Gehäuses,
- ein Montieren des Gehäuses auf dem Kontaktbürstenträger.

## Claims

1. Current sensor device (10) for monitoring the current passing through a brush (1), comprising:
- a brush holder (12) extending in a longitudinal direction between distal (12a) and proximal (12b) ends, and defining a through housing (120) intended to receive, slidably in the longitudinal direction, a brush so that one end of the brush intended to brush against a rotating movable surface protrudes from the brush holder at its distal end,
- a Hall effect sensor (14) arranged to detect a magnetic field,
the current sensor device being **characterized by**:
- a concentrator (16) arranged to concentrate the magnetic fields inside a concentrated magnetic field zone (160) and to protect this zone from the external magnetic fields,
wherein,
- the concentrator (16) is mounted on the brush holder (12) so as to surround at least a part of the brush when the latter is received inside the housing (120) of the brush holder, in particular in a plane perpendicular to the longitudinal direction,
- the Hall effect sensor (14) is mounted on the brush holder (12) at a position located inside the concentrated magnetic field zone (160), so as to measure a value representative of the intensity of the current passing through the brush when the latter is received in the housing of the brush holder.

2. Current sensor device (10) according to claim 1, wherein the concentrator (16) and the Hall effect sensor (14) are located at a position closer to the distal end (12a) then the proximal end (12b) of the brush holder in the longitudinal direction.

3. Current sensor device (10) according to claim 1 or 2, wherein the housing (120) has a cross section in the form of a quadrilateral in a plane extending perpendicularly to the longitudinal direction of the brush holder, and the concentrator (16) surrounds the brush when the latter is received inside the housing on at least three sides of the quadrilateral shape of the housing in this same plane.

4. Current sensor device (10) according to any one of claims 1 to 3, wherein the Hall effect sensor (14) is attached to a sensor support (18) located inside a casing (20) mounted on the brush holder (12).

5. Current sensor device (10) according to claim 4, wherein at least one element selected from the casing and the sensor holder is mounted removably.

6. Current sensor device (10) according to claim 4 or 5, wherein the sensor support is, or comprises, an integrated circuit board, the latter comprising at least one microprocessor or microcontroller for analyzing the data supplied by the Hall effect sensor.

7. Current sensor device (10) according to claim 6, further comprising a connection member arranged to collect and transmit, to a data management system, the data analyzed by the at least one microprocessor or microcontroller.

8. Current sensor device (10) according to any one of claims 1 to 7, wherein the concentrator (16) is attached to the brush holder (12) by means of a support element (22) attached to the brush holder.

9. Current sensor device (10) according to any one of claims 1 to 8, comprising at least one of the following features:
- the brush holder (12) defines at least one holding member (125, 126; 135) cooperating with a holding member (201, 161-163; 231) of at least one element selected from the concentrator, the casing and the support element,
- the casing (20) defines at least one holding member (202) cooperating with a holding member (224) of at least one element selected from the concentrator and the support element,
- the support element (22) defines at least one holding member (220) cooperating with a holding member (161-163) of at least one element selected from the brush holder, the concentrator and the casing.

10. Current sensor device (10) according to any one of claims 1 to 9, wherein the length of the concentrator (16) in the longitudinal direction represents 50% or less of the length of the brush holder, optionally from the distal end of the brush holder.

11. Current sensor device (10) according to any one of claims 1 to 10, wherein the length of the concentrator (16) in the longitudinal direction is equal to or greater than the corresponding length of the Hall effect sensor, optionally the sensor is at a position located in at least one midplane with respect to the concentrator, this midplane being selected from a midplane parallel to the longitudinal direction and a midplane perpendicular thereto.

12. Current sensor device (10) according to any one of claims 1 to 11, wherein the concentrator (16) is made from ferromagnetic material.

13. Current sensor device (10) according to any one of claims 1 to 12, comprising at least one other sensor arranged to measure at least one parameter associated with the state of the brush.

14. Rotating electrical machine (30) comprising at least one current sensor device (10) according to any one of the preceding claims.

15. Method for assembling a current sensor device (10) for monitoring the current of a brush, comprising:
- providing a brush holder extending in a longitudinal direction between distal and proximal ends, and defining a through housing intended to receive, slidably in the longitudinal direction, a brush so that an end of the brush intended to slide against a rotating movable surface protrudes from the brush holder at its distal end,
- mounting a concentrator, arranged to concentrate the magnetic fields inside a concentrated magnetic field zone and to protect this zone from the external magnetic fields, on the brush holder so as to surround at least part of the brush when the latter is received inside the housing (120) of the brush holder, in particular in a plane perpendicular to the longitudinal direction, so that the magnetic field generated by the current flow passing through the brush received in the housing of the brush holder is concentrated by the concentrator in a concentrated magnetic field zone,
- mounting on the brush holder a Hall effect sensor arranged to detect a magnetic field, at a position located inside the concentrated magnetic field zone, so as to measure a value representative of the intensity of the current passing through the brush.

16. Assembly method according to claim 15, wherein the mounting of the Hall effect sensor comprises:
- attaching the Hall effect sensor to a sensor support,
- mounting the sensor support inside a casing,
- mounting the casing on the brush holder.
